Europäisches Patentamt

European Patent Office

Office européen des brevets

(11) Publication number: **0 171 783**
A2

# (12) EUROPEAN PATENT APPLICATION

(21) Application number: **85110103.0**

(22) Date of filing: **12.08.85**

(51) Int. Cl.⁴: **H 01 L 23/52**

(30) Priority: **17.08.84 JP 170412/84**

(43) Date of publication of application:
**19.02.86 Bulletin 86/8**

(84) Designated Contracting States:
**DE FR GB**

(71) Applicant: **HITACHI, LTD.**
**6, Kanda Surugadai 4-chome Chiyoda-ku**
**Tokyo 100(JP)**

(72) Inventor: **Yamamoto, Masakazu**
**A3-1 Hitachi Suzukishinden Shataku**
**1473 Josuihoncho Kodaira-shi(JP)**

(74) Representative: **Patentanwälte Beetz sen. - Beetz jun.**
**Timpe - Siegfried - Schmitt-Fumian**
**Steinsdorfstrasse 10**
**D-8000 München 22(DE)**

(54) **Module board and module using the same and method of treating them.**

(57) The present invention relates to a module board for a computer and a module using the same, and more particularly to a module board and a module having a surface pattern suitable for high density packaging. To bond a repair wire (12) onto a technical exchange pad (5), a wire bonder is normally used, but a fixed or more interval must be provided between an LSI chip and the technical exchange pad (5) so as to secure a working area. Depending on the direction of bonding, however, a required interval changes substantially. The invention is characterized in that junction pads (6) are installed to provide a module board and a module having a surface pattern capable of restricting the direction of bonding to one direction.

*FIG. 3*

TITLE OF THE INVENTION:

Module Board and Module Using the Same and Method
of Treating Them

BACKGROUND OF THE INVENTION:

The present invention relates to a module board for
a computer and a module using the same, and more
particularly to one having a surface pattern suitable
for high density packaging.

Fig. 1 is a schematic diagram illustrating the
overall structure of a conventional module board.
A multiplicity of LSI chips (semiconductor devices) 2
are mounted on the surface of a module board 1, and a
multiplicity of input/output pins 3 are led out from
the rear surface thereof.

Fig. 2 is an enlarged view of the module board
illustrating the peripheral portion of the aforementioned
LSI chip (semiconductor device) 2.

This module board is provided on the surface
thereof with solder pads 4 for mounting LSI chips and
the like as well as technical exchange pads 5 (repair
pads). The technical exchange referred to is effected
to repair such troubles as disconnection and short-
circuiting of a conductive layer (e.g., a signal wire
layer and a power source layer) inside the module board.

An arrangement is made such that this technical exchange can be effected by cutting a printed pattern on the repair pad and connection or the like of a repair wire.

In the case of these conventional module boards, however, no consideration has been paid to the fact that the area for providing technical exchange pads would increase and the LSI's mounting pitch area would become large with increased integration of LSI's, the progress of which has been particularly noticeable in recent years, and with a resultant increase in the number of signal pins or the like. Accordingly, the working area necessary for the aforementioned technical exchange or other purposes becomes extremely limited, thereby presenting a drawback. This problem has been highlighted as an issue which will become increasingly important in the future.

An arrangement of a conventional module board for a computer is disclosed in, for example, U. S. Pat. No. 4,245,273.

SUMMARY OF THE INVENTION:

Accordingly, an object of the present invention is to provide a module board having a surface layer pattern capable of making a technical exchange pad area small.

To attain this object, in order to connect a repair wire to a technical exchange pad, a wire bonder is normally used, but a fixed or greater interval must be provided between a LSI chip and the technical exchange pad so as to secure a working area. In this case, the interval to be secured changes substantially depending on the direction of bonding. The present invention is designed to restrict the direction of bonding and to reduce the overall mounting pitch of the LSI's, and it is characterized in that intermediate pads are provided for restricting the direction of bonding.

BRIEF DESCRIPTION OF THE DRAWINGS:

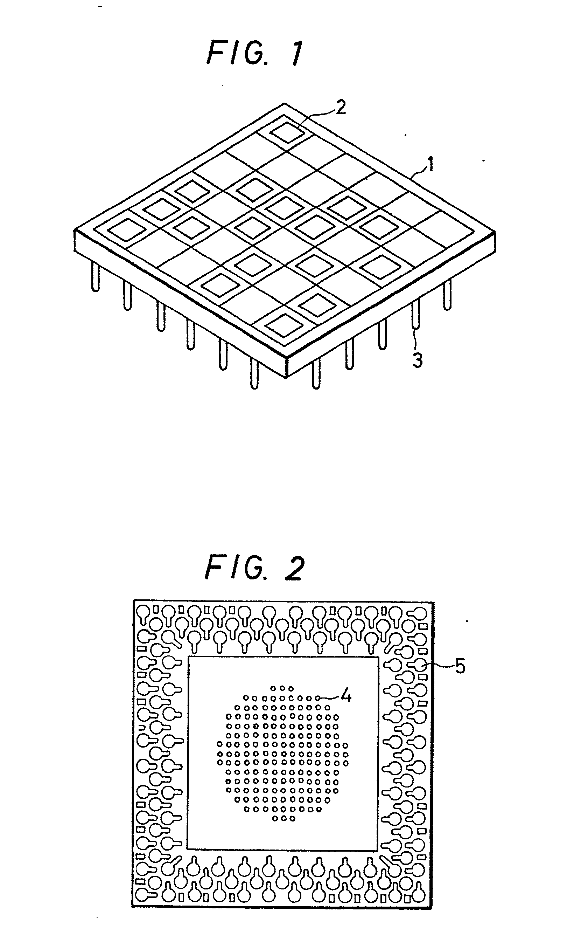

Fig. 1 is a schematic diagram illustrating the overall structure of a conventional module board;

Fig. 2 is a top plan view of a portion of the surface pattern of the conventional module board;

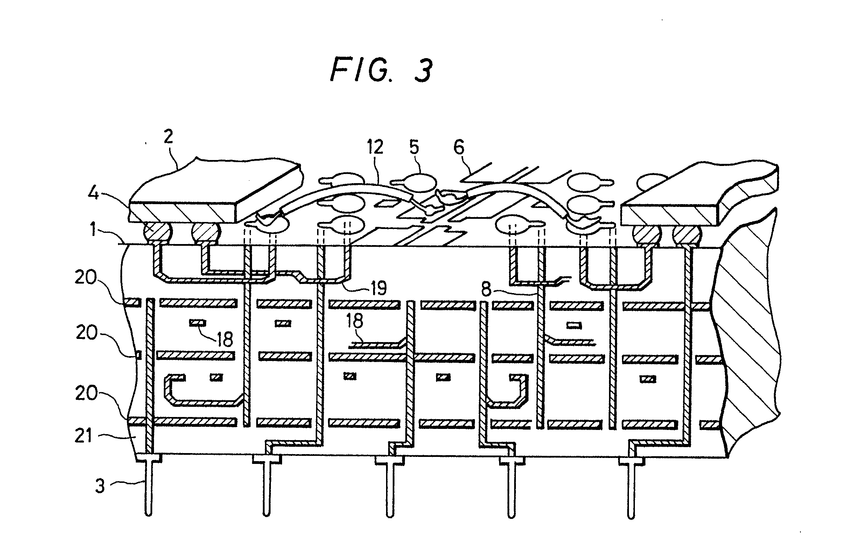

Fig. 3 is a cross-sectional perspective of a module of the present invention;

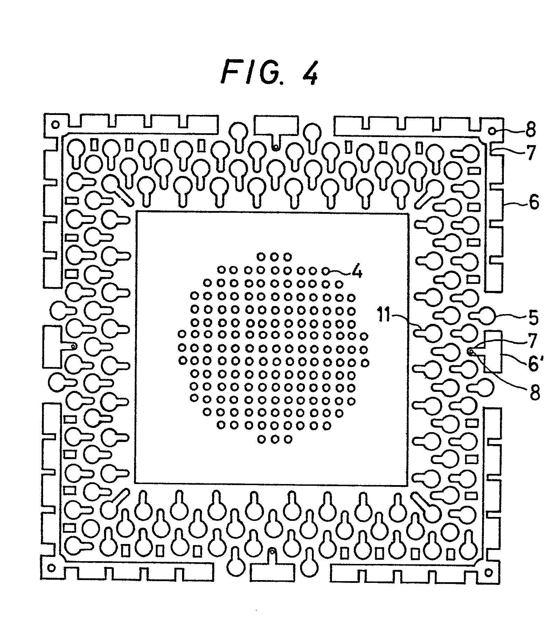

Fig. 4 is a top plan view illustrating a portion of the surface pattern of the module board of the present invention;

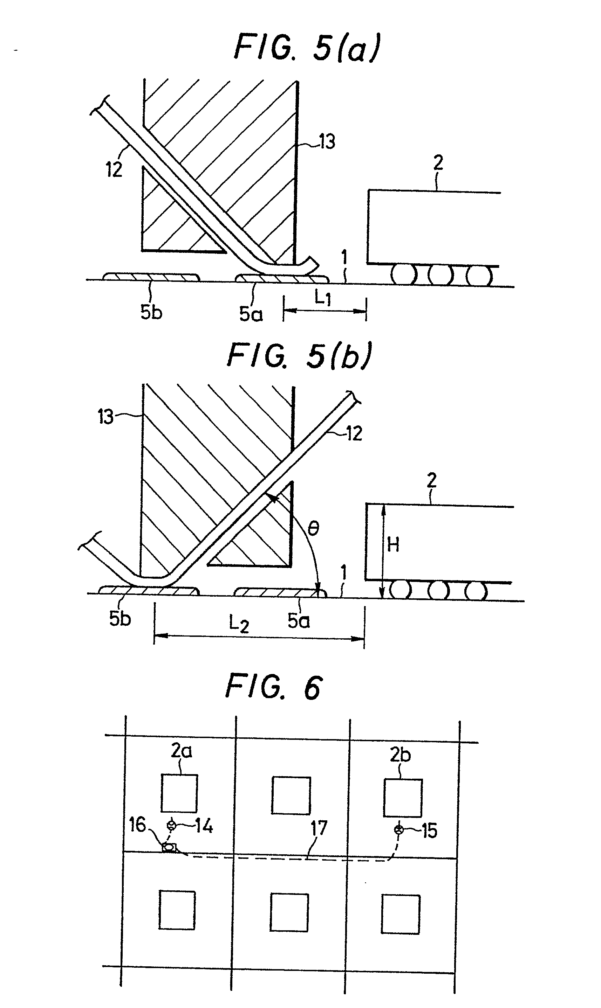

Fig. 5 is a cross-sectional view illustrating the state at the time of wire bonding; and

Fig. 6 is a top plan view schematically illustrating a passage of a repair wire.

0171783

DETAILED DESCRIPTION OF THE PREFERRED EMBODIMENTS:

Description of an embodiment of the present invention will be made hereafter with reference to the drawings. Fig. 3 is a cross-sectional perspective view of a module of the present invention. The inside of the module board 1 is of a multilayer structure comprising: lead wires 19 for electrically connecting each of technical exchange pads with a solder pad 4 in a relationship of one to one correspondence; signal wires 18 for electrically connecting the terminals in position of a plurality of semiconductor devices 2 such as LSI's mounted on one surface of the board; a power source or grounding layer 20 for supplying a predetermined potential to semiconductor devices 2; and insulating layers 21 for electrically insulating these conductive layers. Insulating layers 21 are of insulating material employing, for instance, ceramics or the like. The material of the module board 1 is selected in such a manner that its thermal expansion coefficient will be compatible with that of semiconductor devices 2 mounted. On one surface of the module board 1 are provided solder pads 4 for effecting the so-called CCB (controlled collapse bonding) between an LSI chip (semiconductor device) and the module board 1, technical exchange pads 5 provided in the periphery of the solder pads and electrically connected with solder pads, and electrically insulated junction pads 6 provided in the periphery of the technical exchange pads 5. To effect repair of such troubles as disconnection and short-circuiting of a signal wire 18 inside the module board 1 or to effect a change of logics, the technical pad 5 and the junction pad 6 are bonded by a repair wire 12. Input/output pins 3 are provided on the other surface of the module board 1, as shown in Fig. 3. Each of the input/output pins 3 is electrically connected to each of the technical exchange pads 5 or each of the solder pads 4.

Incidentally, the surface pattern of the above-described module board is arranged such that a plurality of patterns shown in Fig. 3 are provided.

A multiplicity of LSI chips and solder pads 4 for effecting, for instance, CCB connection are formed in an area where semiconductor devices 2 such as LSI chips are mounted on the surface of the module board. A plurality of these solder pads 4 are employed to be connected with one LSI chip. A plurality of these solder pads 4 will be hereafter referred to as a group of solder pads. A plurality of groups of solder pads are provided in predetermined positions on the surface of the module board so as to mount a plurality of LSI chips. As shown in Fig. 4, a square area provided in the surrounding area of groups of solder pads indicate the external configuration of the LSI chip, and a multiplicity of technical exchange pads 5 are formed in the periphery of the LSI chip. Furthermore, a plurality of bonding junction pads 6 are provided in the periphery of the technical exchange pads. The junction pads 6 are connected with each other in several sets on the board surface by means of connecting patterns 7, and are further connected to an inner power source layer by means of a throughhole 8.

As a modification of the junction pads 6, there is one like 6' which is comprised of only one set on the board surface and is connected to the inner power source layer by means of the connecting pattern 7 and the throughhole 8. Each of the junction pads is formed by a member with a slender structure having appropriate recessed portions (connecting patterns 7) in the midway thereof, and the portion of the connecting pattern 7 constituted by the aforementioned recessed portion can be cut by means of a laser or the like, as required, so as to set it in an electrically floated state.

Incidentally, as will be described later, in the stage of fabricating junction pads, it is desirable to connect the pads with the inner power source layer of the module so as to provide the pad surfaces with gold plating. However, since the junction pads have to be set in the electrically insulated state, it is therefore necessary to cut the connecting patterns 7 with a laser or the like.

In this embodiment, the total number of the junction pads 6, 6' provided is the same as the number of technical exchange pads 11 closest to the LSI chip (these technical exchange pads will be hereafter referred to as the innermost side technical exchange pads), among the technical exchange pads provided around the periphery of the LSI chip mounting area. As will be described later, it is necessary that the total number of the junction pads 6, 6' be one half or more of the number of the aforementioned innermost side technical exchange pads provided around the periphery of the LSI chip.

Fig. 5 shows a relative positional relationship among the wedge 13 of a wire bonder, the LSI chip 2, and the technical exchange pad 5 at the time when the repair wire 12 is bonded. Between a first bonding position shown in Fig. 5(a) and a second bonding position shown in Fig. 5(b), the position of the technical exchange pad 5 for allowing the repair wire 12 to be bonded in the case of the first bonding can be made closer to the LSI 2 than in the case of the second bonding. Here, by the first bonding is meant to be the connection of the starting end of the repair wire 12 to the pad, while by the second bonding is meant to be the connection of the junction portion or terminating end portion of the repair wire 12. As for the method of bonding, the starting end portion of the repair wire is connected by the first bonding, and by moving the wire bonder along the repair wire 12 through the hole portion of the wedge, as shown in Fig. 5, the second bonding is carried out when connecting the intermediate portion to the pad. Then, when cutting the repair wire 12, the repair wire 12 is cut after effecting the second bonding.

In Fig. 5, in the case of the first bonding, since only the positional accuracy of the wedge 13 and the LSI chip 2 may be considered, if the distance between the LSI chip 2 and the center of the pad in the peripheral portion closest to the outside edge of the LSI chip 2 is assumed to be L, as shown in Fig. 5, the distance $L_1$ between the wedge 13 and the LSI 2 is approximately 0.1 mm in view of the performance of a currently available wire bonder. Meanwhile, in the case of the second bonding, the repair wire 12 must not be brought into contact with the LSI 2, as shown in Fig. 5(b), and they must be kept apart by a distance determined by the height H of the LSI up to its surface and angle θ formed by the repair wire 12 and the board 1.

Normally, H is approximately 0.5 mm, and θ is approximately 30° to 45°. Therefore, 0.6 to 1.0 mm or thereabout is required for $L_2$ if the positional accuracy with respect to the wedge 13 and the repair wire 12 is also taken into consideration. Repair is carried out to repair a disconnection in the board itself and a short-circuit as well as to effect a change in logics. Since it is impossible to estimate where the repair and exchange would take place, it is necessary to design the module board such as to enable all repairs and exchanges. In the case of a conventional module board, however, there has been a drawback in that since a fixed size of area is required for the second bonding, only the first bonding can be effected with respect to the innermost side technical exchange pad 5a closest to the LSI chip shown in Fig. 5. In other words, it is impossible to effect a repair in which the innermost side technical exchange pad 5a becomes a junction point or the terminal end portion of the repair wire. Accordingly, in the arrangement of a conventional surface pattern, it has been necessary to keep the technical exchange pad away from the LSI chip 2 up to a position shown by a technical exchange pad 5b.

According to the embodiment of the present invention, since the junction pads 6, 6' are provided in correspondence with the technical exchange pads 11 in the innermost side with respect to the LSI chip, the first bonding can constantly be effected with respect to the innermost side technical exchange pads 11 by making use of the junction pads 6, 6'. The procedure of this bonding is described hereafter.

In the present embodiment, as schematically shown in Fig. 6, in the case of connecting the innermost side technical exchange pad 14 and the innermost side technical exchange pad 15 by means of the repair wire 17, the repair wire 17 is first bonded to the pad 14 by the first bonding and is then cut after being bonded to the junction pad 16 by the second bonding. Then, after the pad 15 is bonded by the first bonding, the junction pad 16 is bonded by the second bonding after passing the area of the junction pad, thereby completing the repair. This is necessary because it becomes impossible to effect cooling if the repair wire is placed on the LSI. The mark of a cross 'X' in Fig. 6 denotes a portion of bonding. Incidentally, in cases where the repair wire is long, the repair wire may be attached provisionally to a pad in the midway to prevent the repair wire from becoming excessively lax.

As shown in Fig. 6, since only one junction pad 16 will suffice to connect the innermost side technical exchange pads 14, 15 with respect to LSI chips 2a and 2b, the effective number of junction pads is at minimum one half of the number of the innermost side technical exchange pads. If the number of the junction pads is less than one half of the number of the innermost side technical exchange pads, among the innermost side technical exchange pads, there would be pads that cannot be electrically connected via junction pads. However, since, as described before, the bonding between technical exchange pads is carried out to repair such troubles as a disconnection or short-circuiting of conductive layers (signal wire layers, power source layer, etc.) inside the module board, and since it is impossible to predict where a repair or exchange would take place, it is important to provide junction pads so that all repairs and exchanges can be effected. Accordingly, in the case of junction pads which numbers less than one half of the number of the innermost side technical exchange pads, there will occur cases where it is impossible to effect a repair, and hence a module board with such an arrangement is not effective.

According to the present embodiment, there is an advantage in that the innermost side technical exchange pad can always be provided with the first bonding, and that it is possible to place the technical exchange pad immediately close to the LSI chip. In addition, since the use of the junction pads is restricted to the time of repairing the innermost side technical exchange pads and the frequency of their usage is therefore limited, it is possible to commonly use the area where the repair wire passes and the area of the junction pad, which gives an advantage that the mounting pitch of the LSI can be made smaller than in cases where a repair wire area is provided separately in a portion surrounding the technical exchange pad. Furthermore, according to the present embodiment, since the junction pads are set in an electrically floated state only at the time when they are used, the junction pads are connected to a power source or the like at the time when the boards are produced. For this reason, it becomes possible to effect electroplating by the use of an I/O pin for the power source to apply a thick gold plating suitable for bonding without employing chemical plating which requires an injurious plating liquid such as cynide.

According to the present invention, since it becomes possible to dispose the technical exchange pads in the surrounding portion extremely close to the area of mounting LSI's and other electronic parts, and since it is not necessary to provide an area for passing a repair wire separately in the surrounding portion of the technical exchange pads, the intervals of mounting semiconductor devices such as LSI chips can be made smaller by the margin of the area for passing the repair wire. If 10 repair wires with a thickness of approximately 50 μm are to be passed, this is equivalent to a reduction in the distance of the LSI by 0.5 mm. Supposing that the LSI pitch is approximately 10 mm, this results in a 5% reduction in length and a 10% reduction in area, while, conversely, this improves the mounting density of parts by 10%.

In addition, with respect to junction pads provided in the surrounding portion of the technical exchange pads, it is not necessary to conduct an inspection using probes which is carried out to judge whether or not electrical connections inside the module board have been effected properly. Consequently, it becomes possible to narrow the intervals among unit areas each including one LSI chip that are schematically shown in Fig. 2. In the case of the arrangement of a conventional surface pattern, the technical exchange pads on the outermost side of the unit areas are also subject to electrical inspection, so that probes had to be connected. However, since, in terms of their intervals, probes have to be kept apart by a predetermined distance or more (approx. 1.5 mm), effective use has not been made
of the area between the respective pads in the outermost row in adjacent unit areas.  In the present
invention, however, it is not necessary to subject the
junction pads to inspection since they are electrically
insulated.  Moreover, since the area where junction
pads are provided can be used as a predetermined
distance between the probes, the unit areas can be made
smaller.  In other words, as is apparent from the
foregoing description, the present invention makes it
possible to improve the mounting density of semiconductor devices on the module board, thereby remarkably
contributing to the improved integration of the
aforementioned LSI chips mounted.

**0171783**

WHAT IS CLAIMED IS:

1.    A module board for mounting semiconductor devices, wherein said board comprises on the surface thereof:

a plurality of groups of solder pads (4) provided for soldering a plurality of semiconductor devices, respectively;

a plurality of technical exchange pads (5) provided in the surroundings of a plurality of said respective groups of solder pads;

and electrically insulated junction pads (6).

2.    A module board according to claim 1, wherein the number of said junction pads (6) is one half or more of the number of said technical exchange pads (5) provided in the surrounding portion closets to said groups of solder pads (4).

3.    A module board according to claim 1, wherein said junction pad (6) is shaped such as to have a slender structure with a recessed portion in the midway thereof.

4.    A module board according to claim 1, wherein said junction pads (6) are disposed on the periphery of the surrounding portion of said technical exchange pads.

5.    A module board according to claim 1, wherein each of a plurality of said technical exchange pads (5) contains in the inside thereof a plurality of conductive layers (18,19,20) for being electrically connected with any one of said solder pads among said groups of solder pads.

6.    A module having a plurality of semiconductor
devices and a module board for mounting a plurality of
said semiconductor devices, wherein said module comprises on the surface thereof:

a plurality of groups of solder pads (4) provided for.
soldering each of a plurality of said semiconductor devices;

a plurality of technical exchange pads (5) provided in
the surroundings of a plurality of said respective groups of
solder pads; and

electrically insulated junction pads (6) and repair
wires (12), wherein each of a plurality of said semiconductor
devices are connected to said module board via said groups
of solder pads, and connection between a technical exchange
pad provided in the surrounding portion closest to a
predetermined semiconductor device (hereinafter referred to as
a first semiconductor device) among said semiconductor devices
on the one hand, and another circuit element to be electrically
connected to said first semiconductor device on the other,
is effected by said repair wire via said junction pad.

7.    A module according to claim 6, wherein a technical
exchange pad provided on the surrounding portion closest
to said first semiconductor device on the one hand, and
a technical exchange pad provided on the surrounding
portion closest to the other predetermined semiconductor
device (hereinafter referred to as a second semiconductor device) to be connected electrically
to said first semiconductor device on the other, are
electrically connected by said repair wire via said
junction pad.

8.   A module according to claim 6, wherein the number
of said junction pads is one half or more of the
number of said technical exchange pads provided on the
surrounding portion closest to said groups of solder
pads.

9.   A module according to claim 6, wherein each of
said junction pads has a slender structure with a
recessed portion in the midway thereof and is disposed
on the surrounding portion of said technical exchange pads.

10.  A method of connecting the circuitry in a module,
using a module which is provided on the surface thereof
with a plurality of groups of solder pads for soldering
semiconductor devices and which has groups of technical
exchange pads provided on the surrounding portions of
a plurality of said respective groups of solder pads
and groups of junction pads provided on the peripheral
portion of the surrounding portion of said groups of
technical exchange pads, and comprising the steps of:

connecting one end of a repair wire to one technical exchange pads in the surrounding portion closest to a semiconductor device;

connecting the other end of said repair wire to one of said groups of junction pads; and

connecting to one of said groups of junction pads a repair wire connected to a circuit element which is provided on said module board and which is to be electrically connected to said semiconductor device, thereby electrically connecting said circuit element and said semiconductor device.

11. A method of connecting the circuitry in a module, using a module which is provided on the surface thereof with a plurality of groups of solder pads for soldering semiconductor devices and which has groups of technical exchange pads provided on the surrounding portions of a plurality of said respective groups of solder pads and groups of junction pads provided on the peripheral portion of the surrounding portion of said groups of technical exchange pads, and comprising the steps of:

connecting one end of a repair wire to one technical exchange pads in the surrounding portion closest to a semiconductor device;

connecting the other end of said repair wire to one junction pad in said group of technical exchange pads in the surrounding portion closest to said semiconductor device;

connecting one end of the other repair wire to the other one of technical exchange pads provided in the surrounding portion closest to said semiconductor device; and

connecting the other end of said repair wire to said one junction pad in said groups of junction pads; thereby connecting each other the respective technical exchange pads provided in the surrounding portion closest to said semiconductor device.

0171783

# FIG. 1

# FIG. 2

0171783

FIG. 3

# FIG. 4

0171783

## FIG. 5(a)

## FIG. 5(b)

## FIG. 6